# FASCICULE DE BREVET EUROPEEN

(11) **EP 3 986 743 B1**
(45) Date de publication et mention de la délivrance du brevet: **17.04.2024**
(21) Numéro de dépôt: 20785787.1
(22) Date de dépôt: 19.06.2020
(51) Int. Cl.: B60K 35/00, B60K 37/06, H03K 17/96

(54) **PROCÉDÉ DE PERSONNALISATION ET ÉLÉMENT DE COMMANDE PERSONNALISABLE**
VERFAHREN ZUR ANPASSUNG UND ANGEPASSTES STEUERELEMENT
CUSTOMIZATION METHOD AND CUSTOMIZED CONTROL ELEMENT

(30) Priorité: 24.06.2019 FR 1906798
(43) Date de publication de la demande: 27.04.2022
(73) Titulaire: NOVARES France, 78140 Vélizy-Villacoublay (FR)
(72) Inventeur: REICHHELD, Frédérick, 06500 MENTON (FR); CAZES, Christophe, 78000 VERSAILLES (FR); BOLLIER, François, 06300 NICE (FR)
(74) Mandataire: Germain Maureau
(86) Numéro de dépôt international: PCT/FR2020/051074
(87) Numéro de publication internationale: WO 2020/260809

(56) Documents cités:
- EP-A1- 3 387 514
- DE-A1-102010 032 839
- DE-A1-102018 118 295
- US-B2- 9 432 017

## Description

La présente invention concerne le domaine des véhicules automobiles et plus particulièrement la faculté de personnaliser l'interface de commande d'un véhicule.

L'habitacle d'un véhicule est doté de façon traditionnelle d'une ou plusieurs interfaces qui permettent de commander différentes fonctions
Traditionnellement, les organes de commandes comprennent des boutons poussoirs ou rotatifs, des curseurs sur lesquels agit le conducteur ou un passager pour piloter des fonctions du véhicule telles que le système d'info-divertissement, l'éclairage, le verrouillage centralisé, la climatisation etc.

Les fonctions de l'automobile, tout comme le design de la carrosserie et l'ergonomie de l'habitacle participent à faire de l'automobile un objet auquel les utilisateurs s'identifient. Ainsi, les fonctions proposées par une automobile participent aussi à l'attractivité des clients pour telle automobile plutôt que pour telle autre.

Un inconvénient posé par des commandes réalisées au moyen de boutons ou de curseurs qui reposent sur des systèmes mécaniques ou partiellement mécaniques est que le positionnement desdits boutons est défini de façon définitive lors de la conception de l'habitacle du véhicule.

De ce fait, les boutons ou curseurs de commande sont généralement disposés selon une ergonomie « universelle » décidée par le constructeur pour le plus grand nombre d'utilisateurs qui ne peut pas s'adapter à une ergonomie individuelle.

Par ailleurs, les habitacles de véhicules se dotent d'écrans numériques sur lesquels s'affichent des icônes dans lesquels on peut naviguer de manière tactile ou grâce des molettes de commandes. Les écrans numériques apportent aux conducteurs et passagers une grande richesse de fonctionnalités au prix parfois d'une certaine complexité. Cette complexité due à la richesse d'informations sous forme d'icône, de menus, de choix à sélectionner peut s'avérer délétère ; en effet lorsque les différentes fonctions d'un véhicule sont mises en oeuvre par le conducteur, celui-ci doit cependant conserver son attention à la conduite du véhicule.

Les commandes réalisées sur un écran tactile sont personnalisables sur la surface de l'écran tactile comme le montre, par exemple, le document FR 2 069 208.

Selon ce document, l'adaptation de commande de fonction d'un véhicule aux choix et désirs d'un utilisateur est effectuée en assignant une zone d'une dalle tactile à une fonction du véhicule selon le choix de l'utilisateur et en matérialisant la zone choisie par l'utilisateur et la fonction associée par un repère qui peut être repositionnable pour être réutilisé par un autre utilisateur.

Le procédé de personnalisation montré par ce document est satisfaisant puisqu'un utilisateur peut ainsi adapter un habitacle de véhicule en fonction de ses souhaits. En revanche, le fait de disposer des repères visuels s'avère moins satisfaisant et peut conduire à conférer à l'habitacle un caractère désordonné.

US 9 432 017 concerne un écran avec un système de détection tactile. DE 10 2010 032839 concerne un composant sandwich, i.e. plaque de verre, destiné à être utilisé, par exemple, dans un écran tactile. EP 3 387 514 concerne une rétroaction haptique d'une interface utilisateur. DE 10 2018 118295 concerne un dispositif de commutation à écran tactile.

Un but de la présente invention est d'améliorer l'expérience de conduite d'un utilisateur en améliorant l'ergonomie d'un habitacle et en l'adaptant aux choix individuels d'un utilisateur

Selon un premier aspect l'invention concerne un procédé de personnalisation d'un élément de commande d'un véhicule automobile caractérisé en ce que le procédé comprend les étapes de :
- sélection par un utilisateur d'une série de fonctions préférentielles parmi une bibliothèque de fonctions de commande d'un véhicule :
- association de chaque fonction préférentielle à respectivement un emplacement d'une couche tactile disposée dans une zone d'accostage (3), ledit emplacement de la couche tactile étant configuré pour commander ladite fonction préférentielle ;
- réalisation d'un bandeau amovible avec une série de symboles visuels, chacun des symboles visuels correspondant à une fonction préférentielle définie par l'utilisateur,
- positionnement de l'élément de commande en regard de la couche tactile, le bandeau étant munis de moyens de fixation amovibles et la couche tactile comprenant des moyens de fixation amovibles complémentaires des moyens de fixation amovibles du bandeau.

Selon d'autres caractéristiques du procédé selon l'invention prises de manière isolé ou combinée :
- le bandeau est réalisé par fabrication additive.
- le bandeau est réalisé par fabrication soustractive, du type ablation ou grattage laser
- la zone d'accostage est ménagée à la surface d'une pièce d habitacle de véhicule.

Selon un autre aspect, l'invention concerne un élément de commande personnalisable pour un habitacle de véhicule comprenant :
- un bandeau sur lequel sont affichés une sélection de symboles visuels correspondant à des fonctions préférentielles sélectionnées, le bandeau étant munis de moyens de fixation amovibles et
- et une zone d'accostage du bandeau ménagée dans une surface d'une pièce de l'habitacle, la zone d'accostage comprenant (i) une couche tactile configurable de manière à associer au moins un emplacement de la couche tactile à une fonction de commande préférentielle d'un véhicule sélectionnée par un utilisateur et (ii) des moyens de fixation amovibles complémentaires des moyens de fixation amovibles du bandeau.

Selon d'autres caractéristiques de l'élément de commande selon l'invention prises de manière isolé ou combinée :
- le bandeau comprend des moyens d'identification mémorisant les données correspondant aux fonctions préférentielles affichées sur le bandeau et la zone d'accostage comprend des moyens de lecture desdits moyens d'identification en vue de configurer la couche tactile en fonction dudit bandeau.
- le bandeau comprend une étiquette RFID et la zone d'accostage comprend un lecteur RFID, le lecteur RFID et la couche tactile étant connecté à un bus CAN du véhicule.
- l'élément de commande comprend un module de retour haptique.

Selon un autre aspect, l'invention concerne un véhicule comprenant un habitacle incluant l'élément de commande personnalisable selon l'invention.

Pour sa bonne compréhension, l'invention est décrite en référence aux figures ci-annexées représentant à titre d'exemple non limitatif une forme de réalisation d'un procédé de personnalisation et élément de commande personnalisable.
[Fig.1] représente en perspective une forme de réalisation de l'invention ;
[Fig.2] est une vue en perspective éclatée de la forme de réalisation de la figure 1 ;
[Fig.3] est une vue en coupe de la forme de réalisation de la figure 1 ;

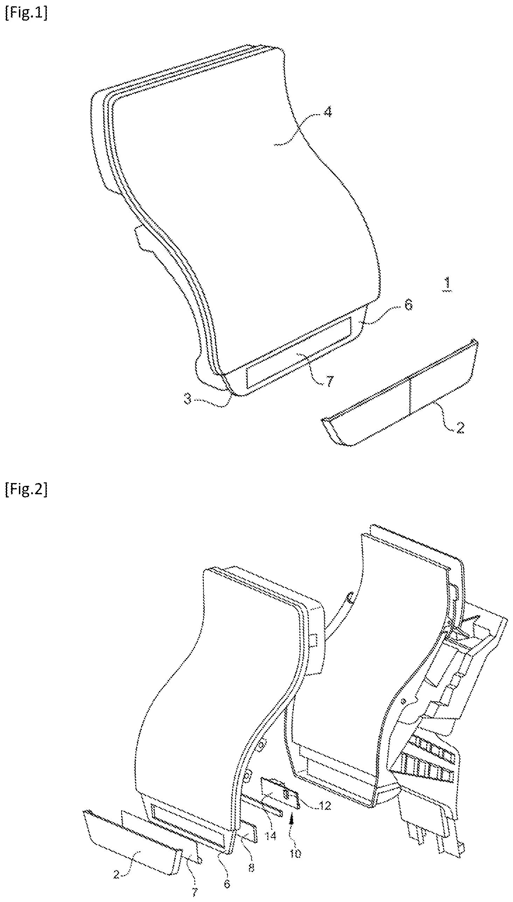

En se reportant à la figure 1, on peut voir que l'invention comprend un élément de commande qui est destiné à venir prendre place dans l'habitacle d'un véhicule.

L'élément de commande 1 comprend un bandeau 2 qui vient se fixer de manière amovible sur une zone d'accostage 3 et, pour cela, l'élément de commande est doté de moyens de fixation amovibles.

Dans l'exemple de réalisation illustrée à la figure 1 de l'invention, l'élément de commande 1 est placé de façon adjacente à une interface de commande 4 d'un véhicule qui fait partie de l'habitacle d'un véhicule qui n'est pas représenté ; l'élément de commande 1 présente une continuité de style avec l'interface de commande 4. Il est précisé que l'interface de commande 4 qui est illustrée à la figure 1 et à la figure 2 n'est en aucune façon limitative de l'invention.

Le bandeau 2 est dans une forme de réalisation préférée de l'invention une pièce de matière plastique ; comme on peut le voir sur la figure 1, le bandeau 2 possède une forme allongée et présente une face externe plane. La face externe plane est configurée pour supporter un affichage d'information par symboles visuels tels que des pictogrammes.

Comme on le verra plus loin, le bandeau 2 est une pièce qui est réalisée à la demande en fonction des choix d'un utilisateur.

Le bandeau 2 est équipé de moyens de fixation amovibles permettant de placer et de retirer le bandeau 2 de l'habitacle d'un véhicule et, dans en particulier de la zone d'accostage 3. Les moyens de fixation amovibles peuvent être, par exemple, des éléments magnétiques ou peuvent être des clips de fixation.

Dans l'exemple de réalisation des figures 1 à 3, la zone d'accostage 3 sur laquelle l'élément de commande peut être fixé comprend une platine ajourée 6 qui est dotée de moyens de fixation complémentaires de ceux du bandeau 2 à savoir magnétiques ou mécaniques.

La platine ajourée 6 reçoit une couche tactile 7 qui fonctionne de façon préférentielle sur le mode capacitif ; dans ce cas de figure, la couche tactile 7 est configurée pour accumuler des charges électriques et lorsqu'un doigt d'un utilisateur touche le bandeau 2, une partie des charges lui est transférée ce qui crée un déficit de charges ponctuel et localisable.

Il est, de plus, prévu que la zone d'accostage 3 comprenne un dispositif de rétroéclairage 8.

De manière optionnelle, l'élément de commande 1 peut être pourvu d'un module de retour haptique 10. Le module de retour haptique 10 peut inclure, comme le montre la figure 2, des jauges de contraintes 12 qui effectuent la détection de la poussée d'un doigt contre le bandeau 2. Les jauges de contraintes 12 sont elles-mêmes disposées à la surface d'une plaque de support 14 et un actionneur qui met en mouvement la dalle 7 par électromagnétisme. Les jauges de contraintes 12 peuvent être remplacées par un film résistif dans une variante de l'invention.

Comme on va le voir ci-après, le bandeau 2 présente la particularité d'être configuré et réalisé à la demande d'un utilisateur et est ainsi individualisé selon les besoins et habitudes de celui-ci.

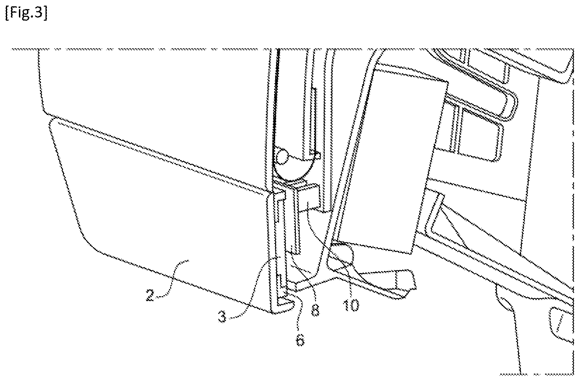

La figure 3 montre l'élément de commande placé sur la zone d'accostage, l'élément de commande 1 étant en appui contre la couche tactile 7.

Un autre aspect de l'invention concerne un procédé de personnalisation d'un élément de commande comprenant un bandeau 2 et des moyens de fixation amovibles de ce bandeau 2.

Le procédé de réalisation d'un élément de commande 1 personnalisé comprend des étapes qui permettent à un utilisateur de définir une ou plusieurs fonctions préférentielles qui, comme on va le voir, vont être affichées sur le bandeau 2. Ainsi, il va être créé un bandeau 2 sur mesure selon le choix personnel d'un utilisateur ; le bandeau 2 va être ensuite placé dans l'habitacle du véhicule pour permettre à l'utilisateur d'agir sur les commandes qu'il a lui-même définies.

L'utilisateur, dans un premier temps, sélectionne une ou plusieurs fonctions auxquelles, pour des raisons personnelles, il souhaite avoir un accès préférentiel. Les fonctions du véhicule peuvent, à titre d'exemple, être le système d'info-divertissement, le système de climatisation, la climatisation, l'appairage avec un téléphone mobile ou encore un choix spécifique dans un menu déroulant d'applications ou toutes autre fonction du véhicule. La sélection des fonctions préférentielles peut se faire sur l'écran de l'interface grâce à une application informatique embarquée dans le véhicule et dont le pilotage peut s'effectuer par l'écran de l'interface.

Cette phase de sélection des fonctions préférentielles en fonction des choix d'un utilisateur n'est pas nécessairement réalisée dans le véhicule. La phase de sélection peut ainsi être effectuée à partir d'un application informatique présente, par exemple, dans le réseau de distribution du constructeur du véhicule en question.

La sélection de fonctions préférentielles peut également être évolutive dans le temps, la bibliothèque de fonctions de commande du véhicule pouvant être mise à jour selon les opérations de maintenance ou dans le cadre de mise à jour à distance selon la technologie dite OTA (Over The Air).

La sélection de fonctions préférentielles peut également être effectué à l'aide d'un smartphone ou tablette électronique relié de manière filière ou sans fil au véhicule.

Sur l'écran d'affichage de l'interface du véhicule ou de l'application informatique, l'utilisateur choisit un menu permettant la sélection de fonctions préférentielles.

L'utilisateur choisit ensuite, sur l'écran d'affichage, un pictogramme destiné à représenter l'élément de commande 4, ledit pictogramme étant associé à une fonction particulière du véhicule;

Le menu demande de choisir l'emplacement souhaité par l'utilisateur de la fonction préférentielle sur la couche tactile 7.

L'utilisateur confirme, éventuellement, que l'emplacement choisi est correct.

Cette phase peut être réitérée en fonction du nombre de fonctions préférentielles que l'élément de commande peut piloter. Dans l'exemple montré sur les figures, l'élément de commande peut, compte tenu de ses dimensions, afficher de un à six pictogrammes représentant les fonctions préférentielles correspondantes.

La définition des fonctions préférentielles de l'utilisateur et de l'ordre dans lequel l'utilisateur souhaite voir apparaitre les pictogrammes associés à chaque fonction préférentielle est alors figée.

Cette définition qui est propre à un utilisateur est alors mise à profit pour fabriquer le bandeau 2.

La fabrication du bandeau 2 peut être faite, par exemple, par fabrication additive. La fabrication additive est un procédé qui se prête particulièrement bien à la fabrication de l'élément de commande selon l'invention qui est produit de manière unitaire en fonction des choix d'un unique utilisateur. Il peut, par exemple, être envisagé d'équiper le réseau de distribution des constructeurs automobiles d'imprimantes tridimensionnelles pour produire des bandeaux 2 selon l'invention à la demande des utilisateurs.

Selon un autre mode de réalisation, la fabrication du bandeau 2 peut être faite par fabrication soustractive, comme par exemple par ablation ou grattage au laser pour rendre les symboles visuels (pictogrammes) visibles par rétroéclairage.

Dans une variante de réalisation, il est prévu que le bandeau 2 soit équipé de moyens d'identification assurant la mémorisation des données concernant les fonctions préférentielles choisies par un utilisateur et l'ordre de ces mêmes fonctions préférentielles. En pratique, les moyens d'identification de l'élément de commande peuvent être une étiquette RFID.

Dans cette variante, l'habitacle du véhicule est doté de moyens de lecture des moyens d'identification qui sont disposés à proximité ou dans la zone d'accostage 3. Dans le cas où le bandeau 2 incorpore une étiquette RFID, les moyens de lecture consistent en lecteur RFID qui de façon conventionnelle effectue la lecture de l'étiquette RFID et en extrait les données concernant les fonctions préférentielles et l'ordre de ces mêmes fonctions préférentielles.

Le lecteur RFID peut être relié au bus CAN du véhicule de manière à ce que les données du bandeau 2 soient transmises à l'un des calculateurs qui équipe de manière habituelle un véhicule. Ces données sont ensuite transmises à la couche tactile 7 pour la configurer de manière à ce qu'un pictogramme présent sur le bandeau 2- par exemple un ventilateur stylisé ou autre - corresponde effectivement à la fonction préférentielle - la climatisation dans l'exemple ci-dessus.

L'invention fournit ainsi l'équivalent, pour un habitacle d'un véhicule, d'un raccourci dans un système d'exploitation informatique. En effet, à l'instar d'un raccourci du domaine informatique, l'invention permet d'accéder directement à une fonction, au choix de l'utilisateur, sans que l'utilisateur n'ait à passer par un chemin ou une combinaison de chemin pour arriver à une fonction que, par habitude, il utilise régulièrement. L'invention contribue ainsi à améliorer l'ergonomie intérieure d'un véhicule. In fine, l'invention contribue à améliorer la sécurité car l'utilisateur, lorsqu'il conduit, peut exercer une attention complète à la conduite puisqu'il a lui-même positionné une ou plusieurs fonctions de commande du véhicule à un emplacement qu'il a lui-même défini. Il peut, de plus, être envisagé que chaque conducteur d'un véhicule dispose d'un bandeau 2 qui lui est propre.

## Revendications

1. Procédé de personnalisation d'un élément de commande d'un véhicule automobile **caractérisé en ce que** le procédé comprend les étapes de :
- sélection par un utilisateur d'une série de fonctions préférentielles parmi une bibliothèque de fonctions de commande d'un véhicule :
- association de chaque fonction préférentielle à respectivement un emplacement d'une couche tactile (7) disposée dans une zone d'accostage (3), ledit emplacement de la couche tactile (7) étant configuré pour commander ladite fonction préférentielle ;
- réalisation d'un bandeau (2) amovible avec une série de symboles visuels, chacun des symboles visuels correspondant à une fonction préférentielle définie par l'utilisateur,
- positionnement du bandeau (2) en regard de la couche tactile (7).

2. Procédé de personnalisation selon la revendication 1, **caractérisé en ce que** le bandeau (2) est réalisé par fabrication additive.

3. Procédé de personnalisation selon la revendication 1, **caractérisé en ce que** le bandeau (2) est réalisé par fabrication soustractive, du type ablation ou grattage laser.

4. Procédé de personnalisation selon l'une des revendications 1 à 3, **caractérisé en ce que** la zone d'accostage (3) est ménagée à la surface d'une pièce d'habitacle de véhicule.

5. Elément de commande personnalisable pour un habitacle de véhicule comprenant
- un bandeau (2) sur lequel sont affichés une sélection de symboles visuels correspondant à des fonctions préférentielles sélectionnées, le bandeau (2) étant munis de moyens de fixation amovibles et
- et une zone d'accostage du bandeau (3) ménagée dans une surface d'une pièce de l'habitacle, la zone d'accostage (3) comprenant (i) une couche tactile (7) configurable de manière à associer au moins un emplacement de la couche tactile (7) à une fonction de commande préférentielle d'un véhicule sélectionnée par un utilisateur et (ii) des moyens de fixation amovibles complémentaires des moyens de fixation amovibles du bandeau (2).

6. Elément de commande personnalisable selon la revendication 5 **caractérisé en ce que** le bandeau (2) comprend des moyens d'identification mémorisant les données correspondant aux fonctions préférentielles affichées sur le bandeau (2) et la zone d'accostage comprend des moyens de lecture desdits moyens d'identification en vue de configurer la couche tactile en fonction dudit bandeau (2).

7. Elément de commande personnalisable selon la revendication 6, **caractérisé en ce que** le bandeau (2) comprend une étiquette RFID et la zone d'accostage comprend un lecteur RFID, le lecteur RFID et la couche tactile étant connecté à un bus CAN du véhicule.

8. Elément de commande personnalisable selon l'une des revendications 5 à 7, **caractérisé en ce que** l'élément de commande comprend un module de retour haptique (10).

9. Véhicule comprenant un habitacle incluant un élément de commande personnalisable selon l'une quelconque des revendications 5 à 8.

## Patentansprüche

1. Verfahren zur Personalisierung eines Steuerelements eines Kraftfahrzeugs, **dadurch gekennzeichnet, dass** das Verfahren die folgenden Schritte umfasst:
- Auswählen einer Reihe bevorzugter Funktionen aus einer Bibliothek von Fahrzeugsteuerfunktionen durch einen Benutzer:
- Zuordnen jeder bevorzugten Funktion zu jeweils einer Position einer taktilen Schicht (7), die in einem Andockbereich (3) angeordnet ist, wobei die Position der taktilen Schicht (7) dazu konfiguriert ist, die bevorzugte Funktion zu steuern;
- Herstellen eines abnehmbaren Bedienfelds (2) mit einer Reihe visueller Symbole, wobei jedes der visuellen Symbole einer vom Benutzer definierten bevorzugten Funktion entspricht,
- Positionieren des Bedienfelds (2) gegenüber der taktilen Schicht (7).

2. Personalisierungsverfahren nach Anspruch 1, **dadurch gekennzeichnet, dass** das Bedienfeld (2) durch additive Fertigung hergestellt wird.

3. Personalisierungsverfahren nach Anspruch 1, **dadurch gekennzeichnet, dass** das Bedienfeld (2) durch subtraktive Fertigung, wie etwa Laserablation oder Laserschaben, hergestellt wird.

4. Personalisierungsverfahren nach einem der Ansprüche 1 bis 3, **dadurch gekennzeichnet, dass** der Andockbereich (3) auf der Oberfläche eines Fahrzeuginnenraumbauteils vorgesehen ist.

5. Personalisierbares Steuerelement für einen Fahrzeuginnenraum, das Folgendes umfasst
- ein Bedienfeld (2), auf dem eine Auswahl von visuellen Symbolen angezeigt wird, die ausgewählten bevorzugten Funktionen entsprechen, wobei das Bedienfeld (2) mit abnehmbaren Befestigungsmitteln versehen ist, und
- und einen Andockbereich des Bedienfelds (3), der in einer Oberfläche eines Innenraumbauteils vorgesehen ist, wobei der Andockbereich (3) (i) eine taktile Schicht (7), die so konfigurierbar ist, dass sie mindestens eine Position der taktilen Schicht (7) mit einer von einem Benutzer ausgewählten bevorzugten Steuerfunktion eines Fahrzeugs verknüpft, und (ii) abnehmbare Befestigungsmittel umfasst, die zu den abnehmbaren Befestigungsmitteln des Bedienfelds (2) komplementär sind.

6. Personalisierbares Steuerelement nach Anspruch 5, **dadurch gekennzeichnet, dass** das Bedienfeld (2) ein Identifikationsmittel umfasst, das die Daten speichert, die den auf dem Bedienfeld (2) angezeigten bevorzugten Funktionen entsprechen, und der Andockbereich ein Mittel zum Lesen des Identifikationsmittels umfasst, um die taktile Schicht entsprechend dem Bedienfeld (2) zu konfigurieren.

7. Personalisierbares Steuerelement nach Anspruch 6, **dadurch gekennzeichnet, dass** das Bedienfeld (2) einen RFID-Tag umfasst und der Andockbereich einen RFID-Leser umfasst, wobei der RFID-Leser und die taktile Schicht mit einem CAN-Bus des Fahrzeugs verbunden sind.

8. Personalisierbares Steuerelement nach einem der Ansprüche 5 bis 7, **dadurch gekennzeichnet, dass** das Steuerelement ein haptisches Rückmeldemodul (10) umfasst.

9. Fahrzeug, das einen Innenraum umfasst, der ein personalisierbares Steuerelement nach einem der Ansprüche 5 bis 8 enthält.

## Claims

1. A method for customizing a control element of a motor vehicle **characterized in that** the method comprises the steps of:
- selecting by a user a series of preferential functions from a library of functions of controlling a vehicle:
- associating each preferential function with respectively one location of a touch layer (7) disposed in a docking area (3), said location of the touch layer (7) being configured to control said preferential function;
- carrying out a removable panel (2) with a series of visual symbols, each of the visual symbols corresponding to a preferential function defined by the user,
- positioning the panel (2) opposite the touch layer (7).

2. The customization method according to claim 1, **characterized in that** the panel (2) is carried out by additive manufacturing.

3. The customization method according to claim 1, **characterized in that** the panel (2) is carried out by subtractive manufacturing, of the laser ablation or scraping type.

4. The customization method according to any of claims 1 to 3, **characterized in that** the docking area (3) is provided on the surface of a vehicle passenger compartment part.

5. A customizable control element for a vehicle passenger compartment comprising
- a panel (2) on which a selection of visual symbols corresponding to selected preferential functions are displayed, the panel (2) being provided with removable fastening means and
- a docking area (3) of the panel provided in a surface of a part of the passenger compartment, the docking area (3) comprising (i) a touch layer (7) configurable so as to associate at least one location of the touch layer (7) to a preferential control function of a vehicle selected by a user and (ii) removable fastening means complementary to the removable fastening means of the panel (2).

6. The customizable control element according to claim 5 **characterized in that** the panel (2) comprises identification means memorizing the data corresponding to the preferential functions displayed on the panel (2) and the docking area comprises means for reading said identification means in order to configure the touch layer according to said panel (2).

7. The customizable control element according to claim 6, **characterized in that** the panel (2) comprises a RFID tag and the docking area comprises a RFID reader, the RFID reader and the touch layer being connected to a CAN bus of the vehicle.

8. The customizable control element according to any of claims 5 to 7, **characterized in that** the control element comprises a haptic feedback module (10).

9. A vehicle comprising a passenger compartment including a customizable control element according to any one of claims 5 to 8.
